# EUROPÄISCHE PATENTSCHRIFT

(11) **EP 0 988 697 B1**
(45) Veröffentlichungstag und Bekanntmachung des Hinweises auf die Patenterteilung: **11.09.2002**
(21) Anmeldenummer: 98936129.0
(22) Anmeldetag: 09.06.1998
(51) Int. Cl.: H03H 9/64, H03H 9/145

(54) **DUALMODE-OBERFLÄCHENWELLENFILTER**
DUAL-MODE SURFACE WAVE FILTER
FILTRE A ONDES DE SURFACE BIMODE

(30) Priorität: 09.06.1997 DE 19724259
(43) Veröffentlichungstag der Anmeldung: 29.03.2000
(73) Patentinhaber: EPCOS AG, 81541 München (DE)
(72) Erfinder: BAIER, Thomas, D-81539 München (DE); STRAUSS, Georg, D-81667 München (DE)
(74) Vertreter: Epping, Wilhelm, Dipl.-Ing.
(86) Internationale Anmeldenummer: DE9801582
(87) Internationale Veröffentlichungsnummer: WO98057429

(56) Entgegenhaltungen:
- EP-A- 0 605 884
- GB-A- 2 110 032
- GB-A- 2 117 992
- US-A- 4 616 197
- RUPPEL C C W ET AL: "SAW DEVICES FOR CONSUMER COMMUNICATION APPLICATIONS" IEEE TRANSACTIONS ON ULTRASONICS, FERROELECTRICS AND FREQUENCY CONTROL, Bd. 40, Nr. 5, 1. September 1993, Seiten 438-451, XP000412997

## Beschreibung

Die Erfindung betrifft ein im folgenden kurz DMS-Filter genanntes, bevorzugt auf LiNbO₃- oder LiTaO₃-Basis realisiertes DMS-Filter gemäß Oberbegriff des Anspruches 1, das insbesondere für HF-Anwendungen einsetzbar ist.

In Kommunikationssystemen werden Signale unsymmetrisch oder symmetrisch verarbeitet, wobei in der Signalführung häufig zwischen beiden Betriebsarten gewechselt wird und so Bedarf an Filtern entsteht, die betrachtet ein-ausgangsseitig - unsymmetrisch/symmetrisch oder symmetrisch/symmetrisch betreibbar sind. Bestimmte Schaltungskonzepte erfordern zudem Filter mit vorstehend aufgezeigten Eigenschaften und zusätzlich unterschiedlichen Ein- und Ausgangsimpedanzen.

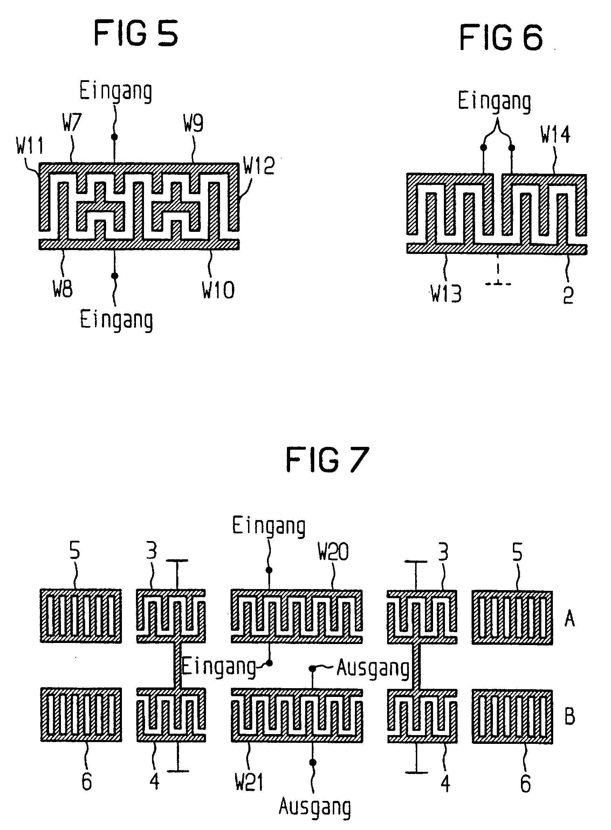

Ein entsprechendes zum Beispiel aus EP-0 605 884 A bekanntes DMS-Filter, das diesen Forderungen in etwa genügt, d.h. symmetrisch oder unsymmetrisch betreibbar ist, zeigt in schematischer Darstellung Fig. 7. Die Struktur dieses DMS-Oberflächenwellenfilters besitzt über Koppelwandler 3, 4 miteinander gekoppelte akustische Spuren A, B mit je Spur innerhalb von kurzgeschlossenen Reflektoren 5, 5 bzw. 6, 6 angeordneten Interdigitalwandlern W20, W21, die als Filtereinund -ausgangswandler wirken und seriell geschaltet sind. Soweit Filter dieser Art realisiert wurden, besaßen sie beidseitig, d.h. filterein- und ausgangsseitig, jeweils gleiche Impedanz, nämlich 50 Ohm.

Ein Oberflächenwellenfilter mit zwei über Koppelwandler miteinander verschalteten Spuren, bei dem die Impedanz von Wandlern durch Wichtung bestimmt ist, ist aus IEEE TREANSACTIONS ON ULTRASONICS, FERROELECTRICS AND FREQUENCY CONTROL, Bd. 40, Nr. 5, 1. September 1993, Seiten 438-451 RUPPEL C.C.W. ET AL: "SAW DEVICES FOR CONSUMER COMMUNICATION APPLICATIONS" bekannt.

Aufgabe der Erfindung ist die Schaffung eines hochselektiven HF-Filters, das gleichfalls symmetrisch oder unsymmetrisch betreibbar ist, also sogenannte BALUN-Funktionalität besitzt, wobei die Impedanz der Ein- und Ausgangswandler wahlweise unterschiedlich festlegbar ist.

Zur Lösung dieser Aufgabe sieht die Erfindung bei einem DMS-Filter gemäß Oberbegriff des Anspruches 1 vor, daß die Impedanz der Ein- und/oder Ausgangswandler des Filters bestimmt ist durch Aufteilung der Ein- und/oder Ausgangswandler je akustischer Spur A, B in mehrere, mindestens teilweise seriell geschaltete Einzelwandler.

Die Ein- und/oder Ausgangswandler können dabei zusätzlich teils in Einzelwandler aufgeteilt sein, die parallelgeschaltet sind.

Durch Änderung, z.B. der geometrischen Struktur uniformer Normalfingerwandler, ist durch Weglaßwichtung oder Überlappwichtung und gegebenenfalls in Kombination hiermit durch Aufteilung der Wandler in mehrere seriell geschaltete Einzelwandler stets die Einstellung einer gewünschten Impedanz eines Einzelwandlers bzw. einer eventuell erforderlichen unterschiedlichen Impedanz von Wandler zu Wandler möglich.

Weitere Merkmale der Erfindung sind den Unteransprüchen, der Beschreibung und Zeichnung entnehmbar.

Es zeigt jeweils in schematischer Darstellung
Fig. 1 und 2 ein erstes und zweites Ausführungsbeispiel eines gewichteten Eingangswandlers nach der Erfindung;
Fig. 3 bis 6 anhand eines dritten bis sechsten Ausführungsbeispiels eine weitere Möglichkeit, die Impedanz hier in vorliegenden Fällen eines Eingangswandlers festzulegen; und
Fig. 7 ein an sich bekanntes eingangs bereits abgehandeltes DMS-Filter.

Die Ausführungsbeispiele zeigen zwar jeweils Eingangswandler. Die Erfindung erstreckt sich jedoch selbstverständlich auch auf Ausgangswandler und Kombinationen von Ein- und Ausgangswandlern. In den Figuren sind jeweils gleiche Elemente mit gleichen Bezugszeichen versehen.

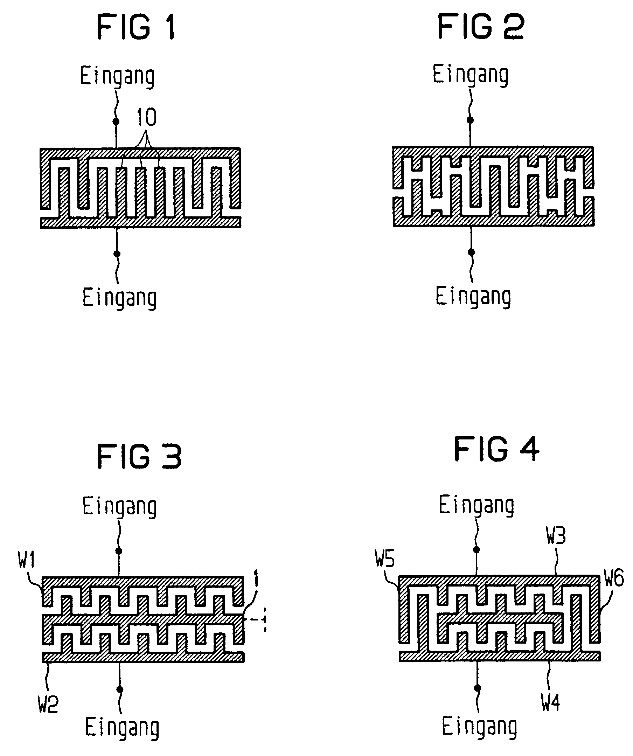

Fig. 1 zeigt eine auf ein nicht dargestelltes an sich bekanntes piezoelektrisches Substrat z.B. auf ein LiNbO₃- oder LiTaO₃-Substrat aufgebrachte Struktur eines Eingangswandlers, der durch Anordnung überlappungsfreier Finger 10, d.h. sogenannter Blindfinger, weglaßgewichtet ist.

In Fig. 2 tritt an die Stelle der Weglaßwichtung eines Eingangswandlers eine Überlappwichtung, die - was im übrigen im umgekehrten Fall auch für die Struktur gemäß Fig. 1 gilt - gegebenenfalls zusätzlich weglaßgewichtet sein kann.

Beim Ausführungsbeispiel nach Fig. 3 ist der Eingangswandler in zur Ausbreitungsrichtung der akustischen Wellen vertikaler Richtung in seriell geschaltete Teilwandler W1, W2 aufgeteilt, wodurch sich die Impedanz im Vergleich zum uniformen Normalfingerwandler um den Faktor 4 erhöht. Die gemeinsame Sammelschiene 1 beider Teilwandler ist je Erfordernis entweder geerdet oder gefloatet.

Wie Fig. 4 und 5 zeigt, kann der Eingangswandler in zur Ausbreitungsrichtung der akustischen Wellen teils vertikaler teils horizontaler Richtung in Teilwandler W3 bis W6 bzw. W7 bis W12 aufgeteilt sein, die seriell bzw. parallelgeschaltet sind. Durch die im Unterschied zum Wandler nach Fig. 3 nur teilweise vertikale Aufteilung wird die Impedanz um einen Faktor < 4 erhöht.

Fig. 6 zeigt schließlich einen Normalfingerwandler, der in zur Ausbreitungsrichtung der akustischen Wellen horizontaler Richtung in zwei zueinander spiegelsymmetrische Teilwandler W13, W14 aufgeteilt ist, die wiederum zueinander seriellgeschaltet sind. Die Impedanz wird durch diese Struktur um den Faktor 4 erhöht. Die gemeinsame Sammelschiene 2 der Teilwandler W13 und W14 kann wiederum geerdet oder gefloatet sein.

## Patentansprüche

1. Dualmode-Oberflächenwellenfilter, das wahlweise symmetrisch oder unsymmetrisch betreibbar ist und über Koppelwandler miteinander gekoppelte akustische Spuren aufweist mit je Spur innerhalb von Reflektoren angeordneten, als Ein- bzw. Ausgangswandler wirksamen Interdigitalwandlern,
**dadurch gekennzeichnet, daß** die Impedanz der Ein- und/oder Ausgangswandler (W20, W21) des Filters bestimmt ist durch Aufteilung der Ein- und/oder Ausgangswandler je akustischer Spur (A, B) in mehrere, mindestens teilweise seriellgeschaltete Einzelwandler (W1, W2; W3, W4; W13, W14).

2. Filter nach Anspruch 1, **dadurch gekennzeichnet, daß** die Ein- und/oder Ausgangswandler teils in Einzelwandler aufgeteilt sind, die parallelgeschaltet sind (Fig. 4, 5).

3. Filter nach Anspruch 1, **dadurch gekennzeichnet, daß** der Ein- und/oder Ausgangswandler weglaßgewichtet ist (Fig. 1).

4. Filter nach Anspruch 1, **dadurch gekennzeichnet, daß** der Ein- und/oder Ausgangswandler überlappgewichtet ist (Fig. 2).

5. Filter nach Anspruch 1, **dadurch gekennzeichnet, daß** der Ein- und/oder Ausgangswandler in zur Ausbreitungsrichtung der akustischen Wellen vertikaler Richtung in Teilwandler (W1, W2) aufgeteilt ist (Fig. 3).

6. Filter nach Anspruch 5, **dadurch gekennzeichnet, daß** die gemeinsame Sammelschiene (1) der Teilwandler (W1, W2) geerdet ist (Fig. 3).

7. Filter nach Anspruch 5, **dadurch gekennzeichnet, daß** die gemeinsame Sammelschiene (1) der Teilwandler (W1, W2) gefloatet ist.

8. Filter nach Anspruch 1, **dadurch gekennzeichnet, daß** der Ein- und/oder Ausgangswandler in zur Ausbreitungsrichtung der akustischen Wellen teils vertikaler teils horizontaler Richtung in Teilwandler (W3 bis W6 bzw. W7 bis W12) aufgeteilt ist, die seriell bzw. parallelgeschaltet sind (Fig. 4, 5).

9. Filter nach Anspruch 1, **gekennzeichnet durch** einen Normalfingerwandler, der in zur Ausbreitungsrichtung der akustischen Wellen horizontaler Richtung in Teilwandler (W13, W14) aufgeteilt ist (Fig. 6).

10. Filter nach Anspruch 9, **dadurch gekennzeichnet, daß** der Normalfingerwandler in zwei zueinander spiegelsymmetrische Teilwandler (W13, W14) aufgeteilt ist (Fig. 6).

11. Filter nach Anspruch 10, **dadurch gekennzeichnet, daß** die gemeinsame Sammelschiene (2) der Teilwandler (W13, W14) geerdet ist.

12. Filter nach Anspruch 10, **dadurch gekennzeichnet, daß** die gemeinsame Sammelschiene (2) der Teilwandler (W13, W14) gefloatet ist.

13. Filter nach einem der Ansprüche 2 bis 12, **gekennzeichnet durch** die wahlweise Kombination ihrer Merkmale je gewünschter Ein- und/oder Ausgangsimpedanz des Filters.

## Claims

1. Dual-mode surface acoustic wave filter which can optionally be operated balanced or unbalanced and has acoustic tracks which are coupled to one another via coupling converters, having interdigital converters for each track, which are arranged within reflectors and act as input and output converters, **characterized in that** the impedance of the input and/or output converters (W20, W21) of the filter is determined by splitting the input and/or output converters into a plurality of individual converters (W1, W2; W3, W4; W13, W14), at least some of which are connected in series, for each acoustic track (A, B).

2. Filter according to Claim 1, **characterized in that** some of the input and/or output converters are split into individual converters which are connected in parallel (Figures 4, 5).

3. Filter according to Claim 1, **characterized in that** the input and/or output converters are omission weighted (Figure 1).

4. Filter according to Claim 1, **characterized in that** the input and/or output converters are overlap weighted (Figure 2).

5. Filter according to Claim 1, **characterized in that** input and/or output converters are split into converter elements (W1, W2) in the direction which is vertical with respect to the propagation direction of the acoustic waves (Figure 3).

6. Filter according to Claim 5, **characterized in that** the common busbar (1) of the converter element (W1, W2) is grounded (Figure 3).

7. Filter according to Claim 5, **characterized in that** the common busbar (1) of the converter element (W1, W2) is floated.

8. Filter according to Claim 1, **characterized in that** the input and/or output converters are split into partial converters (W3 to W6 and W7 to W12, respectively), some of which are vertical in respect to the propagation direction of the acoustic waves, and some of which are horizontal with respect to the propagation direction of the acoustic waves, and these converter elements are connected in series or parallel, respectively (Figures 4, 5).

9. Filter according to Claim 1, **characterized by** a normal finger converter which is split into converter elements (W13, W14) in the direction which is horizontal with respect to the propagation direction of the acoustic waves (Figure 6).

10. Filter according to Claim 9, **characterized in that** the normal finger converter is split into two converter elements (W13, W14) which have mirror-image symmetry with respect to one another (Figure 6).

11. Filter according to Claim 10, **characterized in that** the common busbar (2) of the converter elements (W13, W14) is grounded.

12. Filter according to Claim 10, **characterized in that** the common busbar (2) of the converter elements (W13, W14) is floated.

13. Filter according to one of Claims 2 to 12, **characterized by** the optional combination of its features depending on the desired input and/or output impedance of the filter.

## Revendications

1. Filtre à ondes de surface bimode, qui peut fonctionner à volonté symétriquement ou dissymétriquement et qui comprend des voies acoustiques couplées entre elles par des transducteurs de couplage ayant des transducteurs interdigités disposés pour chaque voie à l'intérieur de réflecteurs et efficaces en tant que transducteurs d'entrée ou de sortie, **caractérisé en ce que** l'impédance du transducteur d'entrée et/ou de sortie (W20, W21) du filtre est déterminée par répartition des transducteurs d'entrée et/ou de sortie de chaque voie (A, B) acoustique en plusieurs transducteurs (W1, W2 ; W3 ; W4 ; W13, W14) individuels au moins partiellement montés en série.

2. Filtre suivant la revendication 1, **caractérisé en ce que** les transducteurs d'entrée et/ou de sortie sont subdivisés en partie en transducteurs individuels qui sont montés en parallèle (figures 4, 5).

3. Filtre suivant la revendication 1, **caractérisé en ce que** le transducteur d'entrée et/ou de sortie est pondéré à suppression (figure 1).

4. Filtre suivant la revendication 1, **caractérisé en ce que** le transducteur d'entrée et/ou de sortie est pondéré à chevauchement (figure 2).

5. Filtre suivant la revendication 1, **caractérisé en ce que** le transducteur d'entrée et/ou de sortie est subdivisé en sous-transducteurs (W1, W2) dans la direction verticale par rapport à la direction de propagation des ondes acoustiques (figure 3).

6. Filtre suivant la revendication 5, **caractérisé en ce que** le rail (1) collecteur commun des sous-transducteurs (W1, W2) est mis à la terre (figure 3).

7. Filtre suivant la revendication 5, **caractérisé en ce que** le rail (1) collecteur commun des sous-transducteurs (W1, W2) est mis à un potentiel flottant.

8. Filtre suivant la revendication 1, **caractérisé en ce que** le transducteur d'entrée et/ou de sortie est subdivisé en sous-transducteurs (W3 à W6 ou W7 à W12) dans la direction en partie verticale en partie horizontale par rapport à la direction de propagation des ondes acoustiques, sous-transducteurs qui sont montés en série ou en parallèle (figures 4, 5).

9. Filtre suivant la revendication 1, **caractérisé par** un transducteur digité normal qui est subdivisé en sous-transducteurs (W13, W14) dans la direction horizontale par rapport à la direction de propagation des ondes acoustiques (figure 6).

10. Filtre suivant la revendication 9, **caractérisé en ce que** le transducteur digité normal est subdivisé en deux sous-transducteurs (W13, W14) symétriques l'un de l'autre comme en un miroir (figure 6).

11. Filtre suivant la revendication 10, **caractérisé en ce que** le rail (2) collecteur commun des sous-transducteurs (W13, W14) est mis à la terre.

12. Filtre suivant la revendication 10, **caractérisé en ce que** le rail (2) collecteur commun des sous-transducteurs (W13, W14) est mis à un potentiel flottant.

13. Filtre suivant l'une des revendications 2 à 12, **caractérisé par** la combinaison à volonté de leurs caractéristiques en fonction de l'impédance d'entrée et/ou de sortie du filtre qui est souhaitée.
